# EUROPEAN PATENT APPLICATION

(11) **EP 1 263 032 A1**
(43) Date of publication of application: **04.12.2002**
(21) Application number: 02011645.5
(22) Date of filing: 29.05.2002
(51) Int. Cl.: H01L 21/316

(54) **Low dielectric constant insulating film, method of forming it, and electric circuit using it**

(30) Priority: 30.05.2001 JP 2001162285
(71) Applicant: ASAHI GLASS COMPANY LTD., Tokyo 100-8405 (JP)
(72) Inventor: Kondoh, Shinji, Kanagawa-ku, Yokohama-shi, Kanagawa (JP); Yokotsuka, Shunsuke, Kanagawa-ku, Yokohama-shi, Kanagawa (JP)
(74) Representative: Müller-Boré & Partner Patentanwälte

(57) **Abstract**

The present invention provides a low dielectric insulating film having low relative dielectric constant, high mechanical strength and high adhesion to substrates, i.e. a low dielectric constant insulating film having one-dimensional through channels from one surface to the other surface and having a relative dielectric constant of at most 3, thus suitable for use as an interlayer film, wherein the film is formed by removing columnar phases from a composite film comprising many columnar phases one-dimensionally grown on the substrate and a matrix phase surrounding them.

## Description

The present invention relates to a low dielectric constant insulating film which has one-dimensionally perforated through channels (hereinafter sometimes referred to as one dimensional through channels), a low dielectric constant insulating film stack which comprises such a low dielectric constant insulting film and a dense layer covering its surface, a multilayer laminate, an electric circuit which comprises the low dielectric constant insulating film, and a method of forming the low dielectric constant insulating film. More particularly, this invention relates to a low dielectric constant insulating film which has heat resistance and high durability and which is useful as a film constituting an insulating layer in a multilayer wiring structure having metal wiring layers and insulating layers stacked one another, in various electric circuits of semiconductor devices or the like, a low dielectric constant insulating film stack, a multilayer laminate, an electric circuit, and methods of forming them with low cost and high reproducibility.

In recent years, efforts have been made to improve the operation speed of central processing units (CPU) or memories to improve the calculation processing speed of computers. To achieve the high speed operation of electric devices such as CPU or memories, it is effective to increase the number of processes done per second by improving clock frequency. However, to achieve stable operation of such devices in a clock frequency of several gigahertz, it is necessary to reduce circuit delay by reducing the wiring resistance or by reducing the dielectric constant of interlaminar insulating films in a multilayer wiring structure. To reduce the wiring resistance, it has become common to use copper as wiring material instead of aluminum wiring which used to be commonly employed, because copper has lower electric resistance.

As for an interlaminar insulating film, SiO₂ has heretofore been used which is formed by CVD and has a dielectric constant of about 4.0. However, various substitute materials have now been proposed for the purpose of solving the problem of circuit delay by lowering the dielectric constant. As an organic type material, a polymer insulating material such as polyimide, or a silicone resin, or a laminate thereof has been used. The organic type polymer material has a relatively low dielectric constant (2.5 to 3.0), but also has problems such that it is hardly processable by a conventional fine fabrication, or its film is likely to be deformed when heated in a subsequent step. Further, a fluorocarbon type polymer is known as a material which does not undergo decomposition by oxidation during O₂ plasma treatment for removing a photoresist in a subsequent step. However, it is difficult to use this material practically, because it does not have sufficient adhesion to metal wirings.

As an inorganic type material, SiOF which is being studied as a CVD material, has achieved a relatively low dielectric constant of from 3.0 to 3.5. However, this material has a problem that the dielectric constant gradually increases as it absorbs moisture. As another approach to reduce the dielectric constant, a method to make an inorganic material to be porous is being investigated.

For example, a method is known to make a porous inorganic film by preparing a ceramic slurry containing fine powder of e.g. silica, coating the slurry on the surface of a substrate by e.g. dipping or spin coating, followed by heating, drying or sintering. However, if the porosity is increased to reduce the dielectric constant, there has been a new problem such that the strength of the film itself or the adhesion of the film to the substrate tends to be low as a trade-off.

Another method has been proposed, in which a porous silica film is obtained by hydrolyzing and polymerizing tetraethoxysilane, followed by drying by a super critical drying method. However, with the film made by such a method, pores in the film are three dimensional, and it has a problem that the mechanical strength is significantly low when its porosity is high around 80%.

As a method to achieve a high porosity of over 50% and a large mechanical strength at the same time, it is conceivable to use a porous material which has one dimensionally continuous through channels. For example, a porous alumina film formed by anodic oxidation of aluminum is known as a film which has one dimensional through channels. (Japanese Examined Patent Publication JP-B-6-37291). The film formed by anodic oxidation of the aluminum has a structure having one dimensional through channels perforated in a matrix of the dense aluminum oxide film from the film surface to the inside of the film, and thus has a feature that the strength of the film itself is high. And, it also has an advantage that the pore diameters of one dimensional through channels are very uniform, and the pore diameters can be controlled within a range of from several nm to several tens nm by changing the production conditions.

However, in the case of a porous alumina film formed by anodic oxidation, the resulting film is restricted to be amorphous alumina, and its substrate is restricted to be an aluminum plate, because of a restriction from the principle of this method utilizing anodic oxidation of an aluminum foil or thicker aluminum plate in the electrolyte. Therefore, there has been a problem that it cannot be used in the case of forming semiconductor circuits.

As described above, various materials have been proposed to lower the dielectric constant of interlaminar insulating films in the multilayer wiring structure to achieve a high operation speed of semiconductor integrated circuits. However, each proposal has its own problems. The approach using an organic type material such as a fluorocarbon polymer is very prospective from the viewpoint of lowering the dielectric constant, because such a material has a low dielectric constant as compared with an inorganic material. However, such a material has a disadvantage that it is an organic substance and thus is basically inferior in heat resistance and mechanical strength to an inorganic material, and further has a problem of low adhesion to metal wirings, various films or members of semiconductor devices.

An inorganic material such as silica has good compatibility with metal wirings, various films or members of semiconductor devices, and has high adhesion and high mechanical strength. However, when a dense material is used, it is difficult to lower the relative dielectric constant. In such a case, it is effective to make such material porous to lower the relative dielectric constant. However, if pores having no three dimensional ordering are introduced, the mechanical strength of the film decreases significantly when the porosity exceeds 50%, whereby there will be a problem that the film tends to be ruptured in a subsequent step.

The present invention has been made to solve the above-mentioned conventional problems, and it is an object of the present invention to provide a low dielectric constant insulating film, a low dielectric constant insulating film stack, a multilayer laminate, a dielectric circuit using the low dielectric constant insulating film, and a method of forming the low dielectric insulating film and low dielectric constant insulating film stack with good reproducibility and low cost, wherein the insulating film has a low dielectric constant especially in the high frequency region, high mechanical strength, excellent adhesion to substrates and applicability to various types of substrates.

The present invention provides a low dielectric constant insulating film which constitutes an insulating layer in a multilayer wiring structure having metal layers and insulating layers stacked one another, having many empty one dimensional through channels each surrounded by a wall continuous from one surface of the film to the other surface of the film, and having a relative dielectric constant of at most 3.

The present invention also provides a low dielectric constant insulating film stack which constitutes an insulating layer in a multilayer wiring structure having metal layers and insulating layers stacked one another, comprising a low dielectric constant insulating film having many empty one dimensional through channels each surrounded by a wall continuous from one surface of the film to the other surface of the film, and having a relative dielectric constant of at most 3, and a dense layer covering the surface of the low dielectric constant insulating film.

The above low dielectric constant insulating film is preferably one formed by removing many one-dimensional columnar phases from a composite film comprising the many one-dimensional columnar phases formed on a substrate by sputtering, or sputtering and heating treatment, and a matrix phase surrounding the columnar phases.

The present invention also provides a multilayer laminate comprising a substrate and a low dielectric constant insulating film stack laminated on the surface of said substrate, wherein the low dielectric constant insulating film stack comprises a low dielectric constant insulating film having many empty one-dimensional through channels each surrounded by a wall continuous from one surface of the film to the other surface of the film, and having a relative dielectric constant of at most 3, and a dense layer covering the surface of said low dielectric constant insulating film.

The present invention also provides an electric circuit which has at least one layer of the above-mentioned low dielectric constant insulating film, the above-mentioned low dielectric constant insulating film stack or the above-mentioned multilayer laminate.

The present invention also provides a method of forming the above mentioned low dielectric constant insulating film, which comprises steps of forming a composite film comprising many one-dimensional columnar phases grown on a substrate and a matrix phase surrounding them, and then removing said one-dimensional columnar phases from said composite film, to form many empty one-dimensional through channels each surrounded by a wall continuous from one surface of the film to the other surface of the film.

In the accompanying drawings:
Fig. 1 is a schematic drawing of a multi-layer laminate containing the low dielectric constant insulating film of the present invention.
Figs. 2a to 2e are schematic diagrams showing the procedure of forming the multi-layer laminate of the present invention.
Figs. 3f to 3j are schematic diagrams showing the procedure of forming the multi-layer laminate of the present invention.

In the Figs., numerals 1 and 10 indicate a substrate, 2 columnar phases, 3 a matrix phase, 4 a composite film, 5 and 11 a low dielectric constant film, 6 an amorphous precursor film, and 7 and 12 a dense film.

Now, the present invention will be described in detail with reference to the preferred embodiments.

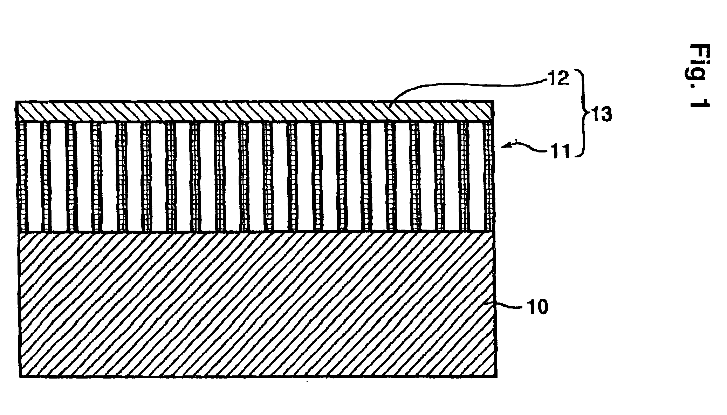

Fig. 1 is a diagram illustrating the cross-section of the low dielectric constant insulating film and the low dielectric constant insulating film stack of this invention. In the diagram, 10 is a substrate, 11 is a low dielectric constant insulating film which has many one dimensional through channels each surrounded by a wall continuous from one surface of the film to the other surface of the film, 12 is a dense layer formed to cover the low dielectric constant insulating film 11, 13 is a low dielectric insulating film stack comprising the low dielectric insulating film 11 and the dense layer 12.

In the low dielectric constant insulating film of the present invention, the matrix phase is a material constituting the low dielectric constant insulating film, and this matrix phase is a dense insulating material.

Now the method of forming the low dielectric constant insulating film of the present invention will be described in the detail.

The low dielectric constant insulating film of the present invention which has pores one dimensionally perforated from the front surface of the film (one dimensional through channels), can be formed by a process comprising two steps. In the first step, a composite film is formed, which comprises one dimensionally grown many columnar phases and a matrix phase surrounding them (hereinafter referred to as a "first step process"), then in the second step, the columnar phases one dimensionally grown in the composite film are removed by etching, so that only the matrix phase will remain (hereinafter referred to as a "second step process").

As a method of forming a composite film in the first step process, there may be mentioned a method wherein the composite film comprising one dimensionally grown columnar phases and a matrix phase surrounding them is formed directly by a physical deposition process (hereinafter referred to as a "first method to form a composite film"), or a second method wherein an amorphous precursor film is formed on a substrate first, and then subjected to a eutectic reaction by heat treatment thereby to form a composite film comprising one dimensionally grown columnar phases and a matrix phase surrounding them (hereinafter referred to as a "second method to form a composite film").

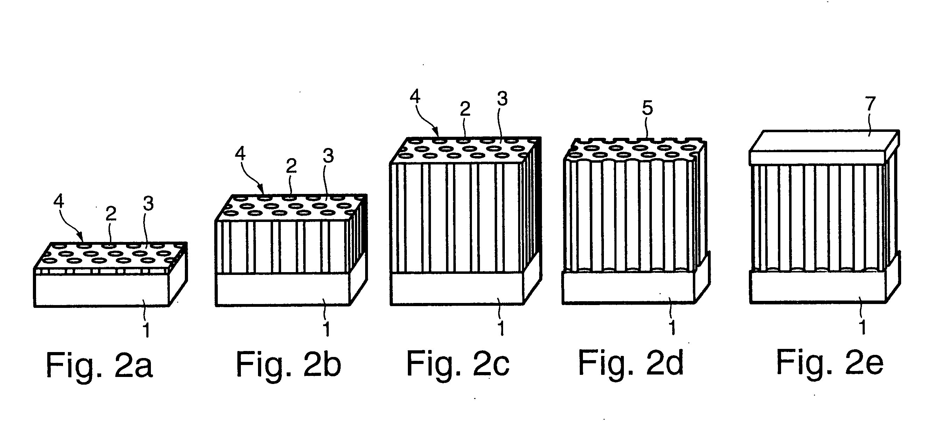

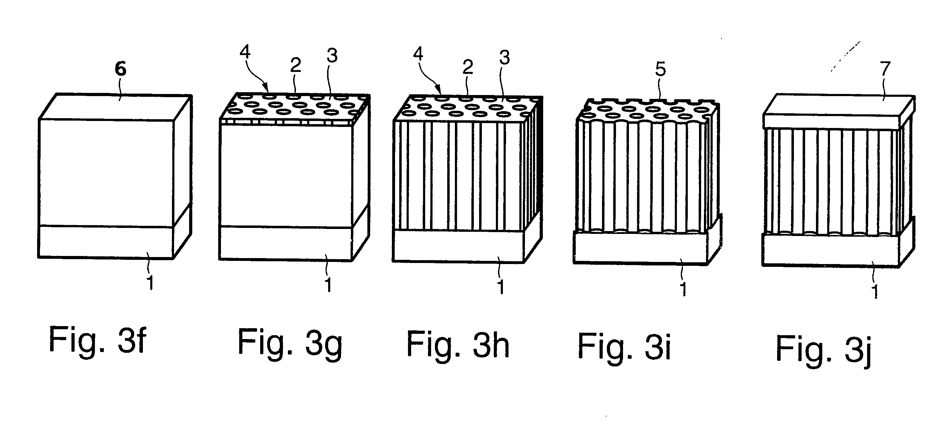

Figs. 2 and 3 are diagrams which show the procedure of forming the low dielectric constant insulating film stack of the present invention. Fig. 2 shows the procedure to form the low dielectric constant insulating film and the low dielectric constant insulating film stack of the present invention by using the first method to form a composite film. Fig. 3 shows the procedure to form the low dielectric constant insulating film and the low dielectric constant insulating film stack of the present invention by using the second method to form a composite film.

Fig. 2a shows the initial stage of formation of a composite film 4 comprising columnar phases 2 and a matrix phase 3 on a substrate by a physical deposition process. Fig. 2b shows the intermediate stage of formation of the composite film 4. Fig. 2c shows the completion of formation of the composite film 4. Fig. 2d shows the stage when a low dielectric constant insulating film 5 comprising the matrix phase 3 is formed by removing one dimensionally grown columnar phases 2 by a selective etching process. Fig. 2e shows the stage when a dense layer 7 is formed to cover the surface of the low dielectric constant insulating film 5.

Fig. 3f shows the stage when an amorphous precursor film 6 containing a transition metal is formed on a substrate 1. Fig. 3g shows the stage when an eutectic microstructure is formed on the surface of the film by heating treatment. Fig. 3h shows the stage when a composite film 4 is finally formed, as the reaction boundary of eutectic decomposition reaches the interface between the film and the substrate by diffusion of oxygen from the surface, whereby a eutectic microstructure comprising one dimensionally grown columnar phases 2 (transition metal oxide crystals) and a matrix phase 3 surrounding them is formed. Fig. 3i shows the stage when a low dielectric constant insulating film 5 constituted by the matrix phase 3 is formed by removing one dimensionally grown columnar phases 2 by selective etching. Fig. 3j shows the stage when a dense layer 7 is formed to cover the low dielectric constant insulating film 5.

Now, the first method to form a composite film will be described in detail.

In the first method to form a composite film, sputtering, vacuum evaporation, chemical vapor deposition, laser abrasion and molecular beam epitaxy are available as physical deposition methods to form the composite film. Among them, sputtering is especially preferred, because it is thereby easy to form a dense film, and a film having high adhesion to the substrate can be obtained, and further, it is excellent in mass productivity and large area coating.

When the composite film is formed by sputtering, the sputtering target constituted by a material to form the columnar phases and a material to form the matrix phase, is not particularly restricted, and it is possible to use a sputtering target formed by mixing a powder of the material to form the columnar phases and a powder of the material to form the matrix phase.

It is also preferred to use a complex target in which many pieces of the material to form the matrix phase each having a size of several mm are mounted on a target made of the material to form the columnar phases. Otherwise, it is also preferred to use a complex target in which many pieces of the materials to form the columnar phases, each having a size of several mm, are mounted on a target made of the material to form the matrix phase.

When the composite film is formed by the first method to form a composite film, the combination of the material for columnar phases and the material for a matrix phase is only required to cause phase separation from each other when the film is formed. In the present invention, since the columnar phases are used as pore portions after etching and the matrix phase is used as a residual phase, the material for the columnar phases is preferably a metal or alloy which is easily grown as columnar phases, is easily soluble by an acid or alkaline solution, has a small binding energy to the matrix phase material and can easily be reduced.

The material for the columnar phases may, for example, be at least one member selected from the group consisting of 3d-transition metals such as V, Cr, Mn, Ni, Fe, Co, Cu, Zn and Ti, and alloys containing such metals as main components, alkaline earth metals such as Mg, and alloys containing them as main components. Further, Al, In, Sn and Pb are also useful.

The material for the matrix phase to be used as the residual phase may, for example, be at least one member selected from the group of oxides such as silica, alumina, titania, mullite, cordierite, spinel, zeolite and forsterite, carbides such as silicon carbide, boron carbide and titanium carbide, nitrides such as silicon nitride, zirconium nitride and titanium nitride, and fluorides such as magnesium fluoride and aluminum fluoride. Such carbides, nitrides and fluorides may contain oxygen.

In the first method to form a composite film, a micro-structure comprising one dimensionally grown columnar phases and a matrix phase surrounding them, is formed by controlling the blend ratio of the materials for the columnar phases and the matrix phase and by controlling the film-forming conditions. For example, when the composite film is formed by sputtering, it is confirmed that the mean diameter of the columnar phases varies depending on the volume proportion of the columnar phases and the matrix phase and the film-forming conditions (such as the Ar gas pressure and the substrate temperature during sputtering).

The mean pore diameter of one dimensional through channels of the low dielectric constant insulating film of the present invention which is finally obtained after etching, can be changed by the blend ratio of the materials for the columnar phases and the matrix phase and by the film-forming conditions (such as the Ar gas pressure and the substrate temperature during sputtering), as the diameters of one dimensional through channels are almost the same as the diameters of one dimensionally grown columnar phases. For example, in the case of Co-SiO₂ type material, when the substrate is not heated, it is confirmed that the particle size of Co in the film is about 40 nm when the film is formed under an Ar gas pressure of 8 Pa, while the particle size of Co is 8 nm when the film is formed under an Ar gas pressure of 2 Pa.

The second method to form a composite film will now be described in detail.

In this second method to form a composite film, a physical deposition method such as sputtering, vacuum evaporation, laser abrasion or molecular beam epitaxy, a solution method such as a sol-gel method, spray pyrolysis or wet coating, or a plating method, may be used as a method of forming an amorphous precursor film. Among them, sputtering is particularly preferred, since a dense film can easily be obtained, a film having high adhesion to the substrate can be obtained, and further, it is excellent in mass-productivity and large-area coating.

When the amorphous precursor film is formed by sputtering, a target comprising a material to form the columnar phases and a material to form the matrix phase is, for example, used. This target is not particularly restricted, and a mixture of a powder of the material to form the columnar phases and a powder of the material to form the matrix phase can be used as a target. For example, in the case of forming a Fe-Si-O type amorphous precursor film, a mixture of FeO powder and SiO₂ powder can be used as the target.

In the second method to form a composite film, a combination of a transition metal, other metal and oxygen may be mentioned as a combination of elements contained in the amorphous precursor film which is initially formed. The transition metal may, for example, be one which forms a separate compound phase as separated from other metals included in the film, after heating treatment, but it is preferably at least one member selected from the group consisting of 3d-transition metals such as V, Cr, Mn, Ni, Fe, Co, Cu, Zn and Ti, alloys containing such metals as the main components, and rare earth elements such as multi-valence cation Ce, Nd, Sm and Er, in view of the handling efficiency during heating treatment. The metal element other than the transition metal, may be one which is not reactive with the transition metal in the subsequent heat treatment.

This metal element becomes a matrix phase surrounding columnar phases (needle crystals of a transition metal compound) by heat treatment and becomes a component constituting a film which has one dimensional through channels, after etching. Accordingly, it is selected depending upon the particular purpose of the film. It may, for example, be Si, Al, Mg, Zr, In or Sn.

When the amorphous precursor film is formed by sputtering, the diameter of the columnar phases one dimensionally grown in the subsequent heating treatment varies depending on the Ar gas pressure in the sputtering process. For example in the case of a Fe-Si-O type film, if a film formed under an Ar gas pressure of 2 Pa is subjected to heating treatment at 600°C, hematite (Fe₂O₃) having a diameter of about 4 nm will separate out. However, if a film formed under an Ar gas pressure of 8 Pa is subjected to the same heating treatment, hematite having a diameter of about 20 nm will separate out. The diameters of one dimensional through channels are about the same as the diameters of one dimensionally grown columnar phases. Accordingly, the mean diameter of one dimensional through channels of the low dielectric constant insulating film of the present invention finally obtainable after etching, can be controlled by the film-forming conditions (such as the Ar gas pressure during sputtering).

In the second method to forming a composite film, the amorphous precursor film comprising a transition metals, other metal and oxygen is subjected to heating treatment to induce a eutectic decomposition reaction, whereby a transition metal oxide and other metal oxide will separate out by exsolution. It is important that such two phase separation from the amorphous phase takes place simultaneously and from the film surface. The heat treating conditions may be any as long as the eutectic decomposition reaction takes place. As for the temperature, it can be selected within a range such that the eutectic decomposition reaction occurs and proceeds at a sufficient reaction speed. Specifically, a temperature from about 400 to 650°C is preferred.

To let the eutectic decomposition reaction take place, it is necessary to change the valency of the transition metal. For this purpose, a method of treating the amorphous precursor film in an oxidizing atmosphere and a method of treating it in a reducing atmosphere are available. In the case of a eutectic reaction of oxides, if the treatment is carried out in a reducing atmosphere, heterogeneous nucleation is likely to occur, and there may be a case wherein a uniform eutectic microstructure can hardly be formed. In such a case, the heating treatment is carried out in an oxidizing atmosphere, so that a uniform eutectic microstructure can be formed.

Now, the second step process will be described in detail.

In the second step process, only the one dimensionally stretched columnar phases are removed by selective etching using an acid solution or an alkaline solution, from the composite film formed by first step process. The acid to be used in this etching treatment is selected from those which are suitable to remove columnar phases selectively, such as sulfuric acid, hydrochloric acid, nitric acid, oxalic acid and acetic acid.

For example, to remove metal cobalt from a metal cobalt/silica composite film formed by the first method to form a composite film, the film may be treated with an aqueous nitric acid solution of 0.1N (0.1×10⁺³ mol/m³) only for a few minutes, whereby only metal cobalt can be completely removed. And, in the case of a Fe-Si-O type composite film formed by the second method to form a composite film, it can be selectively etched by dipping the film in an aqueous the hydrochloric acid solution of about 6N (about 6×10⁺³ mol/m³), as one dimensionally grown hematite is soluble in an aqueous hydrochloric acid solution, while silica is not soluble in the same solution.

The low dielectric constant insulating film of the present invention is one formed as described above, it is a low dielectric constant insulating film which has many one dimensional through channels each surrounded by a wall continuous from one surface of the film to the other surface, and its relative dielectric constant can be of any value between the relative dielectric constant of the dense material itself constituting this low dielectric insulating film and 1 which is the relative dielectric constant of air, depending on the porosity of the film. Specifically, the relative dielectric constant K of the low dielectric constant insulating film having one dimensional through channels of the present invention can be expressed by the formula K=K₀×(1-P)+1×P, where P is the porosity, and K₀ is the relative dielectric constant of the dense material, since the relative dielectric constant of air is 1.

The relative dielectric constant of the low dielectric constant insulating film of the present invention in a high frequency range (1 MHz to a few GHz) is preferably at most 3.0. The low dielectric constant insulating film of the present invention is made of at least one member selected from the group consisting of oxides, carbides, nitrides, borates and fluorides. The material is selected depending upon the particular purpose of the film. But, an oxide is most preferred as the material for the low dielectric constant insulating film of present invention, from the viewpoint of durability, strength, chemical stability, forming efficiency, etc.

The mean pore diameter of one dimensional through channels of the present invention is preferably from 1 to 500 nm. If it is less than 1 nm, the one dimensionally stretched phases are not continuous, and consequently, they tend not to be removed by etching treatment and often remain in the matrix phase in a substantial amount. If the phases to be removed remain this way, there will be local variation of the dielectric constant, whereby the film can not be used stably.

If the mean pore diameter of the channels is more than 500 nm, there may often exist large channels (about 500 to 1,000 nm in diameter), whereby a metal wiring pattern of a metal film formed above or below the large channels, is likely to be disturbed, or its strength tends to be low, such being undesirable. The mean pore diameter of the channels is particularly preferably within a range of from 1 to 10 nm. Namely, when the process condition is selected to form a film having a mean pore diameter of more than 10 nm, large channels (about 50 to 100 nm in diameter) are likely to form after etching treatment, which tends to cause the disturbance of a metal wiring pattern formed on this low dielectric constant insulating film.

Further, the porosity in the low dielectric constant insulating film of present invention is preferably from 50 to 90%. If it is less than 50%, sufficient control of the dielectric constant tends to be impossible, and if it exceeds 90%, the strength of the film or the adhesion between the film and the substrate is likely to decrease.

The relative dielectric constant of the low dielectric constant insulating film of the present invention takes a value between the relative dielectric constant of the dense material of the matrix phase constituting this low dielectric constant insulating film and 1 which is the relative dielectric constant of air, depending on the porosity. The relative dielectric constant decreases as the porosity increases, and it becomes close to the relative dielectric constant of dense material if the porosity is small. By selecting the material and porosity appropriately, it is possible to form a film having a significantly low dielectric constant. Accordingly, it is possible to provide a film having both durability and low dielectric constant.

For example, it is possible to realize a film having both durability and low dielectric constant, if a low dielectric constant insulating film of present invention is formed by forming one dimensional through channels, by using a material having high durability but a low dielectric constant, such as titania, silica, alumina, silicon nitride, aluminum nitride, tin oxide, zinc oxide, tungsten oxide or nickel oxide.

In the second aspect of the present invention, a low dielectric constant insulating film stack comprising a low dielectric constant insulating film and a dense layer stacked thereon, is formed by forming at least one dense layer, preferably a dense insulating layer made of an inorganic or organic insulating material, to cover the surface of the above-mentioned low dielectric constant insulating film. This dense insulating film is provided for the purpose of preventing the permeation of a lubricant into the porous low dielectric constant insulating layer during a chemical mechanical polishing (CMP) process.

There is no particular restriction to the thickness of this dense insulating layer for a barrier, but if it is thinner than 10 nm, it is often useless as a barrier, because it will be worn by the polishing process, and if the thickness is more than 1,200 nm, it may also be useless for reducing the delay effect, since the thickness is about the same as that of the low dielectric layer. Therefore, it is preferred that this thickness is in the range of 10 to 1,200 nm.

By forming such a dense layer on the surface of the low dielectric constant insulating film, it is possible to prevent the lubricant from permeating into the low dielectric constant insulating film during CMP process. This dense film is not limited to be a dense insulating film and can be a dense film having other characteristics and functions depending on the particular purpose.

The material to be used for the dense insulating layer is not particularly restricted as long as it has insulating properties and appropriate mechanical strength. Various materials including oxides and organic materials having insulating properties can be used, but it is ideal to use the same material as the low dielectric insulating film, if the characteristics such as the adhesion with a low dielectric constant film and heat expansion, are taken into consideration. Namely, if silicon dioxide is used as the material for the low dielectric insulating film, it is preferred to use silicon dioxide as the material for the barrier insulating layer.

As a method of forming a dense insulating layer, a physical method such as sputtering, evaporation, CVD or laser abrasion treatment, or a wet method such as a sol-gel method or a coating method, is available. However if the wet method is used, the solvent often permeates into the low dielectric insulating film, which causes various problems such as rupture of the film when its volatile components scatter during subsequent heat treatment. Therefore, it is preferred to use a physical method to form this dense insulating layer.

The substrate on which the low dielectric constant insulating film of present invention is formed is not particularly restricted, and can be selected appropriately depending on the application. When the first method to form a composite film is used, a substrate or a film made of e.g. glass, silicon, various ceramics materials (including sapphire (single crystal of alumina)), metal or plastics can be used. If the second method to form a composite film is used, a substrate or a film made of e.g. glass, silicon, various ceramics materials (sapphire (single crystal of alumina) for example), or heat resisting metals can be used. As the heat resisting metals, oxidation resistant alloys such as stainless steel and Hastelloy constituted by Fe, Ni, Cr or V can be used.

The low dielectric constant insulating film of the present invention is useful as an insulating film for various multilayer wiring structures having metal wiring layers and insulating layers. For example, it is useful as an insulating film constituting an electric circuit for a semiconductor device, particularly for a central processing unit (CPU) or memory for a computer.

The low dielectric insulating film of the present invention has a relatively large porosity, as it has through channels continuous from the surface to the inside of the film. The channels do not disturb the circuit because they are sufficiently small as compared with the width of wirings of a semiconductor electric circuit, and in terms of electric characteristics, the relative dielectric constant of the film is between the dielectric constant of the dense material and the dielectric constant of the air (relative dielectric constant 1.00).

Further, the low dielectric constant insulating film of the present invention has a continuous matrix phase surrounding one dimensional through channels, and fundamentally has high film strength and high adhesion to the substrate as compared with a conventional porous inorganic film of the same material and porosity. The reason for the high mechanical strength is such that the matrix surrounding one dimensional through channels is completely continuous and monolithic in the case of the film of the present invention, while the conventional porous inorganic film is constituted by ceramic grains loosely connected by sintering or the like.

In terms of the adhesion to the substrate, a film having especially high adhesion can be obtained by forming the composite film of the first step (including the amorphous precursor film formed by the second method to form a composite film) by sputtering or the like.

Further, a conventional porous inorganic film has had a trade off problem that if the porosity of the film is increased to reduce the dielectric constant, the mechanical strength of the film and adhesion to the substrate, tend to deteriorate. Whereas, the low dielectric insulating film of the present invention can achieve high film strength and high adhesion to the substrate at the same time without affecting the low dielectric constant, and thus, a low dielectric constant insulating film having low dielectric constant and high durability can be realized.

Now, the present invention will be described in further detail with reference to Examples. However, it should be understood that the present invention is by no means restricted to such specific Examples.

### EXAMPLE 1

A thin film comprising two phases of metal Co and SiO₂ was formed on a silicon substrate having a thickness of 1.2mm by sputtering by means of the first method to form a composite film. A complex target having 5 mm square SiO₂ glass chips mounted on a metal Co target having a diameter of 6 inches, was used for the sputtering. The amount of the SiO₂ glass chips was adjusted so that they occupied 30% of the total surface area of one side of the target.

The above metal Co is a material to form the columnar phases, and SiO₂ is a material to form the matrix phase. After evacuating the vacuum chamber to 5×10⁻⁴ Pa, Ar gas was introduced, and the flow rate was adjusted so that the gas pressure in the vacuum chamber became 2 Pa, whereby plasma was generated by inputting an RF power of 600 W. The deposit rate was about 0.25 nm/sec., and during the film formation, the substrate was heated at about 200°C. The formed Co-SiO₂ composite film thus formed, was observed by TEM (a transmission electron microscope), whereby it was found that Co crystal grains having a mean diameter of about 8 nm were grown in columnar shape and amorphous SiO₂ was separated out at the grain boundaries.

As a second step, the Co-SiO₂ composite film having a thickness of 1000nm prepared by the above method, was dipped in the 0.1N (0.1×10⁺³ mol/m³) aqueous nitric acid solution for 5 minutes to dissolve and remove Co particles, whereby virtually all Co grains were eluted out and a transparent film remained. The mean pore diameter was about 8 nm. The film after Co columnar phases were removed from the Co-SiO₂ composite film, was observed by SEM (scanning electron microscope), whereby it was found that the film was uniform without significant contrast except the grainy material having the diameter of about 5 nm remained in some places on the film. Further, it was confirmed from a cross-sectional image that a film having longitudinal structure remained in close contact with the substrate without a gap between them.

The porosity of the low dielectric insulating film of the present invention thus formed, was estimated from the isothermal sorption property of N₂ and was found to be about 79%. Further, the relative dielectric constant of the above-mentioned low dielectric constant insulating film of SiO₂ having one dimensional through channels was obtained from the result of capacitance measurement at a frequency of 10 kHz and was found to be about 1.8, which is significantly smaller than the relative dielectric constant (about 4.0) of dense silica (SiO₂).

As a dense layer, a dense SiO₂ film having a thickness of about 50 nm was formed on the obtained low dielectric constant insulating film by sputtering. Using a SiO₂ target for the sputtering, the film was formed by conventional RF magnetron sputtering. The durability of the obtained complex insulating film was examined by a Taber abrasion test, whereby no exfoliation of the film or no change in transmittance was observed even after 10 revolutions.

The Taber abrasion test was performed by using a commercial CS100 type spin wheel for Taber abrasion test and an abrasion paper equivalent to AA180 abrasion paper of JIS R6252 standard, and spinning it 10 revolutions at 60 rpm under a load of 500 g to abrade the film. The abrasion tests in the following Examples were performed in the same manner. Further, the complex film was heated at 600°C in an Ar gas atmosphere, but no such a phenomenon as deformation of the film was observed.

### COMPARATIVE EXAMPLE 1

A coating liquid was prepared by polymerizing a solution having tetraethoxysilane dissolved in an isopropyl alcohol (IPA) solvent at a concentration of 0.5 mol/ℓ, by adding hydrochloric acid thereto. The coating liquid was spin-coated on a silicon substrate and left for 10 minutes to let the polymerization proceed. Then, the sample was dipped in the IPA solution for 24 hours, then heated at 235°C under a pressure of 4.8 MPa to make a super critical condition, then depressurized and dried to obtain a desired porous silica film. The porosity of the film was about 80%, and the relative dielectric constant was about 1.6. The durability was examined by the same Taber abrasion test as Example 1, whereby the film was exfoliated, and its transparency was impaired by 10 revolutions. Further, the sample was heated at 600°C in an Ar inert gas atmosphere, whereby the film deformed, and the thickness of the film decreased by 45%.

### EXAMPLE 2

A Co-SiO₂ composite film having a thickness of 800 nm was formed in the same manner as Example 1 except that the amount of SiO₂ crystal was adjusted so that it occupied 60% of one side surface of the target. The internal structure of this Co-SiO₂ composite film was such that the amorphous SiO₂ matrix phase surrounded the columnar phases of Co crystal grains in the same manner as the Co-SiO₂ composite film obtained in the Example 1. However, the mean diameter of Co crystal grains was about 8 nm, and the thickness of amorphous SiO₂ at the grain boundaries was twice as thick as that in Example 1.

The 800 nm thick film sample thus formed, was dipped in the 0.1N (0.1×10⁺³ mol/m³) aqueous nitric acid solution for 5 minutes to dissolve and remove Co grains. In the same manner as in Example 1, virtually all Co columnar phases were eluted out, and the SiO₂ matrix phase at the grain boundaries remained. The mean diameter of the channels was about 8 nm. The porosity of the low dielectric insulating film was about 60%, which was lower than in the case of Example 1. According to the reduction of the porosity, the relative dielectric constant at 10 kHz became 2.4, which was higher than the relative dielectric constant in Example 1.

The durability of this low dielectric constant film was measured by the same Taber abrasion test as Example 1, whereby no exfoliation of the film or no change in transmittance, etc. was observed by 10 revolutions. Further, a heating test was also performed in the same manner as in Example 1, and no deformation of the film was observed.

### EXAMPLE 3

A Co-Si₃N₄ complex film was formed by sputtering on the 1.2 mm thick soda lime glass, as follows. A complex target having 0.5 mm square Si₃N₄ chips mounted on a 6 inch diameter metal Co target was used for the sputtering. The amount of Si₃N₄ chips was adjusted so that they covered 40% of the total surface area of one side of the target. The vacuum chamber was evacuated to 5×10⁻⁴ Pa, then the Ar gas was introduced, and its flow rate was adjusted so that the gas pressure inside of the vacuum chamber became 2 Pa. Then, plasma was generated by applying an RF power input of 600W. The deposition rate was about 0.35 nm/sec, and the substrate was heated at 200°C during the deposition.

The internal structure of the Co-Si₃N₄ complex film thus formed was such that an amorphous Si₃N₄ matrix phase surrounded columnar phases of Co crystal grains, which was very similar to the film structure obtained in Example 1. However, the mean diameter of the Co grains was about 7 nm in this case.

Co grains were dissolved and removed by dipping the about 400 nm thick film sample in a 0.1N (0.1×10⁺³ mol/m³) aqueous nitric acid solution for 5 minutes. In the same manner as in Example 1, virtually all Co columnar phases were eluted, and the Si₃N₄ matrix phase at the grain boundaries remained. The mean pore diameter was about 7 nm. The porosity of the film was about 70%, and the relative dielectric constant was about 2.8 at 10 kHz. Thus, the film was found to be useful as a low dielectric constant insulating film.

The durability of this low dielectric constant insulating film was examined by the same Taber abrasion test as in Example 1, whereby no exfoliation or no change in transmittance was observed by 10 revolutions. Further, the same heating test as in Example 1 was performed, and no deformation of the film was observed.

### EXAMPLE 4

A platinum electrode was formed on a 1.0 mm thick heat resisting glass (Corning #7059 glass) substrate by using vacuum evaporation, and a three component amorphous precursor film of Fe-Si-O was formed by sputtering. A substance formed by mixing Fe₃O₄ powder and SiO₂ powder in volume proportions of 70% and 30%, respectively, followed by sintering, was used as the target for the sputtering. The vacuum chamber was evacuated to 5×10⁻⁴ Pa, Ar gas was introduced. The flow rate of the Ar gas was controlled so that the gas pressure inside the vacuum chamber became 2 Pa, and plasma was generated by inputting an RF power of 4.4 W/cm². The deposition rate was about 0.2 nm/second in this case.

The cross-sectional structure of the deposited amorphous precursor film was observed by SEM, whereby it was found that an amorphous film having a thickness of about 1,200 nm was formed on the platinum electrode. The amorphous film formed was very dense without having internal defects such as cracks or pores. This amorphous film was subjected to heat treatment at 600°C in air for 2 hours. The film after the heat treatment was observed by TEM, whereby it was found that one dimensionally stretched needle crystals of hematite (Fe₂O₃) and silica (SiO₂) surrounding them constituted a eutectic microstructure. Hematite crystals extended from the surface of the film toward the interface with the substrate, perpendicularly to the surface of the film, and their diameters were about 4 nm.

Finally, the film heat-treated by the above method, was dipped in an about 6N (about 6×10⁺³ mol/m³) aqueous hydrochloric acid solution at room temperature for 48 hours together with the substrate, and thus, hematite was selectively removed. The microstructure of the cross-section of the film was observed by TEM whereby it was found that one dimensional through channels having a diameter of about 4 nm which was about the same size as the hematite before acid treatment, were present in the remaining silica. The porosity of the film was about 75%, and the relative dielectric constant at 10 kHz was 2.0. Thus, the film was found to be useful as a low dielectric constant insulating film.

The durability of this low dielectric constant film was examined by the same Taber abrasion test as in Example 1, whereby no change in transmittance, etc. was observed after 10 revolutions. Further, the same heating test as in Example 1 was also performed, and no deformation of the film was observed.

### EXAMPLE 5

A platinum electrode was formed on a 1.0 mm heat resisting glass (Corning #7059 glass) substrate by vacuum evaporation, and a three component amorphous precursor film of Fe-Si-O was formed by sputtering. A substance formed by mixing Fe₃O₄ powder and SiO₂ powder in volume proportions of 70% and 30%, respectively, followed by sintering, was used as the target for the sputtering. The vacuum chamber was evacuated to 5×10⁻⁴ Pa, and an Ar gas was introduced. The flow rate of the Ar gas was controlled so that the internal gas pressure of the vacuum chamber became 8 Pa, and then plasma was generated by inputting an RF power of 4 W/cm². The deposition rate in this case was about 0.1 nm/second.

The cross-sectional structure of the amorphous precursor film was observed by SEM, whereby it was found that an amorphous film having a thickness of about 1,000 nm which was about the same as in Example 4, was formed on the glass substrate. The amorphous film formed was very dense without internal defects such as cracks or pores. This amorphous film was subjected to heat treatment at 600°C in air for 2 hours. The Fe₂O₃-SiO₂ composite film formed by the heat treatment was observed by TEM, whereby it was found that one dimensionally elongated needle crystals of hematite and silica surrounding them constituted a eutectic microstructure in the same manner as in Example 4, and the diameter was about 20 nm.

Finally, the film heat-treated by above method, was dipped in an about 6N (6×10⁺³ mol/m³) aqueous hydrochloric acid solution at room temperature for 48 hours together with the substrate, and thus hematite was selectively removed. The cross-sectional microstructure of the film was observed by TEM, whereby it was found that one dimensional through channels having about the same diameter as that of hematite before acid treatment were present in the remaining silica film. The porosity of the film was about 72%, and the relative dielectric constant was 1.8 at 10 kHz. Thus the film was found to be useful as a low dielectric constant insulating film.

The durability of this low dielectric constant insulating film was examined by the same Taber abrasion test as in Example 1, whereby no exfoliation of the film or no change in transmittance was observed. Further, the same heating test as in Example 1 was performed, and no film deformation was observed.

The low dielectric constant film of present invention has many one dimensional through channels surrounded by a wall continuous from one surface of the film to the other surface of the film, whereby the film has a low relative dielectric constant, especially in high frequency range, and high mechanical strength and durability, and is excellent in adhesion to various substrate materials, and it is further excellent in adhesion to metal wirings or various films and components of semiconductor devices.

By using the above low dielectric constant insulating film of the present invention, a low dielectric constant insulating film which has various compositions and is applicable to various types of substrates, a low dielectric constant insulating film stack, a multilayer laminate and an electric circuit, can be provided. Further, the above low dielectric constant insulating film and low dielectric constant insulating film stack with excellent characteristics can be easily manufactured by using the forming process of the present invention.

The entire disclosure of Japanese Patent Application No. 2001-162285 filed on May 30, 2001 including specification, claims, drawings and summary are incorporated herein by reference in its entirety.

## Claims

1. A low dielectric constant insulating film which constitutes an insulating layer in a multi-layer wiring structure having metal layers and insulating layers stacked one another, wherein said low dielectric constant insulating film has many empty one-dimensional through channels each surrounded by a wall continuous from one surface of the film to the other surface of the film, and has a relative dielectric constant of at most 3.

2. The low dielectric constant insulating film according to Claim 1, wherein said film is formed by removing many one-dimensional columnar phases from a composite film comprising the many one-dimensional columnar phases and a matrix phase surrounding the columnar phases, which are formed on a substrate by sputtering, or sputtering and heating treatment.

3. A low dielectric constant insulating film stack which constitutes an insulating layer in a multi-layer wiring structure having metal layers and insulating layers stacked one another, wherein said film stack comprises:
a low dielectric constant insulating film which has many empty one-dimensional through channels each surrounded by a wall continuous from one surface of the film to the other surface of the film, and has a relative dielectric constant of at most 3;and a dense layer covering the surface of said low dielectric constant insulating film.

4. The low dielectric constant insulating film stack according to Claim 3, wherein said low dielectric constant insulating film is formed by removing many one-dimensional columnar phases from a composite film comprising the many one-dimensional columnar phases and a matrix phase surrounding the columnar phases, which are formed by sputtering, or sputtering and heating treatment.

5. A multi-layer laminate comprising a substrate and a low dielectric constant insulating film stack laminated on the surface of said substrate, wherein the low dielectric constant insulating film stack comprises:
a low dielectric constant insulating film which has many empty one-dimensional through channels each is surrounded by a wall continuous from one surface of the film to the other surface of the film, and has a relative dielectric constant of at most 3; and
a dense layer covering the surface of said low dielectric constant insulating film.

6. The multi-layer laminate according to Claim 5, wherein said low dielectric constant insulating film is formed by removing many one-dimensional columnar phases from a composite film comprising the many one-dimensional columnar phases and a matrix phase surrounding the columnar phases, which are formed by sputtering, or sputtering and heating treatment.

7. The low dielectric constant insulating film according to Claim 1, wherein said film is made of at least one member selected from the group consisting of oxides, carbides, carbides containing oxygen, nitrides, nitrides containing oxygen, borides, borides containing oxygen, fluorides, and fluorides containing oxygen.

8. The low dielectric constant insulating film according to Claim 1 or 7, wherein the one-dimensional through channels in said low dielectric constant insulating film have a mean pore diameter of from 1 nm to 10 nm.

9. The low dielectric constant insulating film according to Claim 1, 7 or 8, which has a porosity of from 50% to 90%.

10. The low dielectric constant insulating film stack according to Claim 3, wherein said insulating film is made of at least one member selected from the group consisting of oxides, carbides, carbides containing oxygen, nitrides, nitrides containing oxygen, borides, borides containing oxygen, fluorides, and fluorides containing oxygen.

11. The low dielectric constant insulating film stack according to Claim 3 or 10, wherein the one-dimensional through channels in said low dielectric constant insulating film have a mean pore diameter of from 1 nm to 10 nm.

12. The low dielectric constant insulating film stack according to Claim 3, 10 or 11, wherein said low dielectric constant insulating film has a porosity of from 50% to 90%.

13. The multi-layer laminate according to Claim 5, wherein said low dielectric constant insulating film is made of at least one member selected from the group consisting of oxides, carbides, carbides containing oxygen, nitrides, nitrides containing oxygen, borides, borides containing oxygen, fluorides, and fluorides containing oxygen.

14. The multi-layer laminate according to Claim 5 or 13, wherein the one-dimensional through channels in said low dielectric constant insulating film have a mean pore diameter of from 1 nm to 10 nm.

15. The multi-layer laminate according to Claim 5, 13 or 14, wherein said low dielectric constant insulating film has a porosity of from 50% to 90%.

16. An electric circuit comprising at least one layer of the low dielectric constant insulating film as defined in Claim 1, 7, 8 or 9.

17. An electric circuit comprising at least one layer of the low dielectric constant insulating film stack, as defined in Claim 3, 10, 11 or 12.

18. An electric circuit comprising at least one layer of the multi-layer laminate as defined in Claim 5, 13, 14 or 15.

19. A method of forming the low dielectric constant insulating film as defined in Claim 1, 7, 8 or 9, which comprises steps of:
forming a composite film comprising many one-dimensional columnar phases grown on a substrate and a matrix phase surrounding them; and then
removing said one-dimensional columnar phases from said composite film, to form many empty one-dimensional through channels each surrounded by a wall continuous from one surface of the film to the other surface of the film.

20. A method of forming the low dielectric constant insulating film as defined in Claim 1, 7, 8 or 9, which comprises steps of:
forming a composite film comprising many one-dimensional columnar phases and a matrix phase surrounding them, which are formed on a substrate by sputtering, or sputtering and heating treatment; and then
removing said one-dimensional columnar phases from said composite film, to form many empty one-dimensional through channels each surrounded by a wall continuous from one surface of the film to the other surface of the film.

21. A method of forming the low dielectric constant insulating film stack as defined in Claim 3, 10, 11 or 12, which comprises steps of:
forming a composite film comprising many one-dimensional columnar phases grown on a substrate and a matrix phase surrounding them;
removing said one-dimensional columnar phases from said composite film, to form many empty one-dimensional through channels each surrounded by a wall continuous from one surface of the film to the other surface of the film; and then
covering said low dielectric constant insulating film with a dense layer.

22. A method of forming the low dielectric constant insulating film stack as defined in Claim 3, 10, 11 or 12, which comprises steps of:
forming a composite film comprising many one-dimensional columnar phases and a matrix phase surrounding them, which are formed on a substrate by sputtering, or sputtering and heating treatment;
removing said one-dimensional columnar phases from said composite film, to form many empty one-dimensional through channels each surrounded by a wall continuous from one surface of the film to the other surface of the film; and then
covering said low dielectric constant insulating film with a dense layer.
